# EUROPEAN PATENT APPLICATION

(11) **EP 2 651 041 A1**
(43) Date of publication of application: **16.10.2013**
(21) Application number: 12734724.3
(22) Date of filing: 12.01.2012
(51) Int. Cl.: H04B 1/08

(54) **HIGH-FREQUENCY MODULE**

(30) Priority: 14.01.2011 JP 2011006314
(71) Applicant: Mitsumi Electric Co., Ltd., Tama-shi Tokyo 206-8567 (JP)
(72) Inventor: MACHIDA, Yuji, Tama-Shi Tokyo 206-8567 (JP)
(74) Representative: Regimbeau
(86) International application number: PCT/JP2012/050524
(87) International publication number: WO 2012/096354

(57) **Abstract**

There is provided a high frequency module including a part mounted on one surface of a board; an electrode for connecting the part formed on the one surface and an apparatus for mounting the high frequency module; and a first insulating layer, which is formed on the one surface and is configured to cover the part, wherein the electrode is formed on a surface of the first insulating layer such that at least a part of the electrode and the first insulating layer are successively formed.

## Description

### TECHNICAL FIELD

The present invention relates to a high frequency module for receiving a high frequency signal.

### BACKGROUND ART

In an exemplary high frequency module, a part is mounted on a single side of a board and a mounting surface for the part is covered by a shield case made of a metal. In the high frequency module, an electrode is formed on a back surface of the mounting surface for the part. The electrode is provided to connect the high frequency module with the main body of a communication apparatus. In another exemplary high frequency module, parts are mounted on both surfaces of a board, and part mounting portions are shielded by a shield case made of a metal. In a double-side mounted high frequency module, a pin is formed for connecting the main body of the communication apparatus and the high frequency module with the board outside the shield case, and a wiring pattern on the board is connected with the pin.

Because the exemplary single-side mounted high frequency module and the exemplary double-side mounted frequency module have a structure where the shield case covers the board, it is inconvenient in thinning the high frequency module.

In another high frequency module for achieving thinness, a resin molded layer for covering a single-side mounted part mounted on a board, and a shield layer is formed on the resin molded layer. For example, Patent Document 1 discloses a circuit module which does not use a metallic case and has a resin molded layer and metallic layer formed on the circuit module.

[Patent Document 1] Japanese Unexamined Patent Application Publication No. 2004-172176

### DISCLOSURE OF THE INVENTION

### PROBLEMS TO BE SOLVED BY THE INVENTION

However, there are problems that the number of manufacturing steps and/or the cost increase in a high frequency module having a complicated structure.

The present invention is provided to solve the above problems in consideration of the above situation. The object of the present invention is to provide a high frequency module which can reduce the number of the manufacturing steps and the cost to contribute the thinness of the high frequency module.

### MEANS FOR SOLVING PROBLEMS

Accordingly, embodiments of the present invention may provide a novel and useful high frequency module solving one or more of the problems discussed above.

The present invention adopts the following structure in order to achieve the above object.

The present invention provides a high frequency module (100) including a part (112) mounted on one surface of a board (110); an electrode (116) for connecting the part (112) formed on the one surface and an apparatus for mounting the high frequency module (100); and a first insulating layer (114), which is formed on the one surface (110B) and is configured to cover the part (112), wherein the electrode (116) is formed on a surface of the first insulating layer (114) such that at least a part of the electrode (116) and the first insulating layer (114) are successively formed.

Further, the high frequency module of the present invention includes another part (111) mounted on another surface (110A) of the board (110); and a second insulating layer (113) formed to cover said another part (111) mounted on said another surface (110A).

Further, the high frequency module of the present invention includes an antenna pattern (119), which is formed on a surface of the second insulating layer (113) and is configured to receive a high frequency signal.

Further, the high frequency module of the present invention includes an antenna pattern (119), which is formed on said another surface (110A) of the board (110) and is configured to receive a high frequency signal.

The reference symbols in the above parentheses are attached to facilitate understanding only as an example. Of course, the present invention is not limited to what is readable with the above mode illustrated in figures.

### EFFECT OF THE INVENTION

According to the present invention, the number of manufacturing steps and the cost are reduced and simultaneously contribution to the thinness of the high frequency module is obtainable.

### BRIEF DESCRIPTION OF DRAWINGS

FIG. 1 illustrates a high frequency module of a first embodiment;
FIG. 2 is a cross-sectional view of the high frequency module taken along a line A-A;
FIG. 3A illustrates a method of manufacturing a high frequency module of the first embodiment;
FIG. 3B illustrates the method of manufacturing the high frequency module of the first embodiment;
FIG. 3C illustrates the method of manufacturing the high frequency module of the first embodiment;
FIG. 3D illustrates the method of manufacturing the high frequency module of the first embodiment;
FIG. 4 illustrates dicing of the high frequency module of the first embodiment;
FIG. 5A illustrates a method of manufacturing a high frequency module of a second embodiment;
FIG. 5B illustrates the method of manufacturing the high frequency module of the second embodiment;
FIG. 5C illustrates the method of manufacturing the high frequency module of the second embodiment;
FIG. 6A illustrates an electrode part of the high frequency module of the second embodiment;
FIG. 6B illustrates an electrode part of the high frequency module of the second embodiment;
FIG. 6C illustrates an electrode part of the high frequency module of the second embodiment;
FIG. 6D illustrates an electrode part of the high frequency module of the second embodiment;
FIG. 6E illustrates an electrode part of the high frequency module of the second embodiment;
FIG. 7 illustrates a high frequency module of a third embodiment;
FIG. 8 is another view illustrating a high frequency module of a third embodiment;
FIG. 9 illustrates a high frequency module of a fourth embodiment.;
FIG. 10A illustrates an exemplary high frequency module; and
FIG. 10B illustrates an exemplary high frequency module.

### BEST MODE FOR CARRYING OUT THE INVENTION

An electrode for connecting a main body of a communication apparatus with a high frequency module may be formed on a back surface of a mounting surface of a board of the high frequency module for mounting an electronic part. Therefore, the high frequency module can be directly connected with the board of the main body of the communication apparatus.

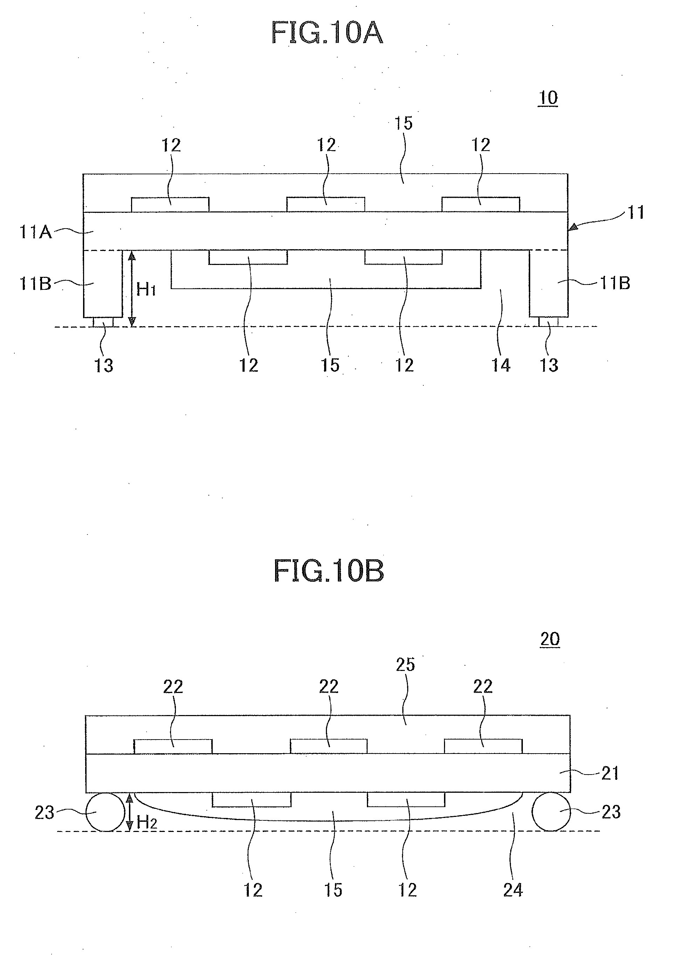

Further, in a high frequency module using a resin molded layer, double-side mount of electronic parts is possible. FIGs. 10A and 10B illustrate exemplary high frequency modules. FIG. 10A is a cross-sectional view schematically illustrating a high frequency module 10. FIG. 10B is a cross-sectional view schematically illustrating a high-frequency module 20.

Referring to FIG. 10A, the high frequency module 10 may be formed such that the board 11 has a mounting portion 11A for mounting a part 12 and an electrode forming portion 11B, in which an electrode 13 is formed to mount the high frequency module 10 on the main body of a communication apparatus. In the high frequency module 10, a space 14 is provided between the main body of the communication apparatus and the board 11 by forming the electrode forming portions 11B. The space 14 is used for double-side mount of the parts 12 on both surfaces of the board 11. Further, resin molded layers 15 are formed on both surfaces of the board 11 of the high frequency module 10 to cover the parts 12. At this time, the thickness of the resin molded layer 15 can be made smaller than the height H1 of the space 14.

Referring to FIG. 10B, the parts 22 may be mounted on both surfaces of the board 21 of the high frequency module 20. Further, solder balls 23, which are to be electrodes for connecting the high frequency module 20 with the communication apparatus, are formed on a surface of the board 21 connecting the board 21 with the body of the communication apparatus. In the high frequency module 20, a space 24 is provided between the main body of the communication apparatus and the board 21 by forming the solder balls 23. The space 24 is used for double-side mount of the parts 22 on both surfaces of the board 21. Further, resin molded layers 25 are formed on both surfaces of the board 21 of the high frequency module 20 to cover the parts 22. At this time, the thickness of the resin molded layer 25 can be made smaller than the height H2 of the space 24. Although it is not illustrated, a shield layer may be formed on any one of the resin molded layers.

As described, the high frequency module using the resin molded layer may be configured such that the parts are mounted on both surfaces of the board, and the high frequency module is directly connected with the board of the main body of the communication apparatus.

### (First Embodiment)

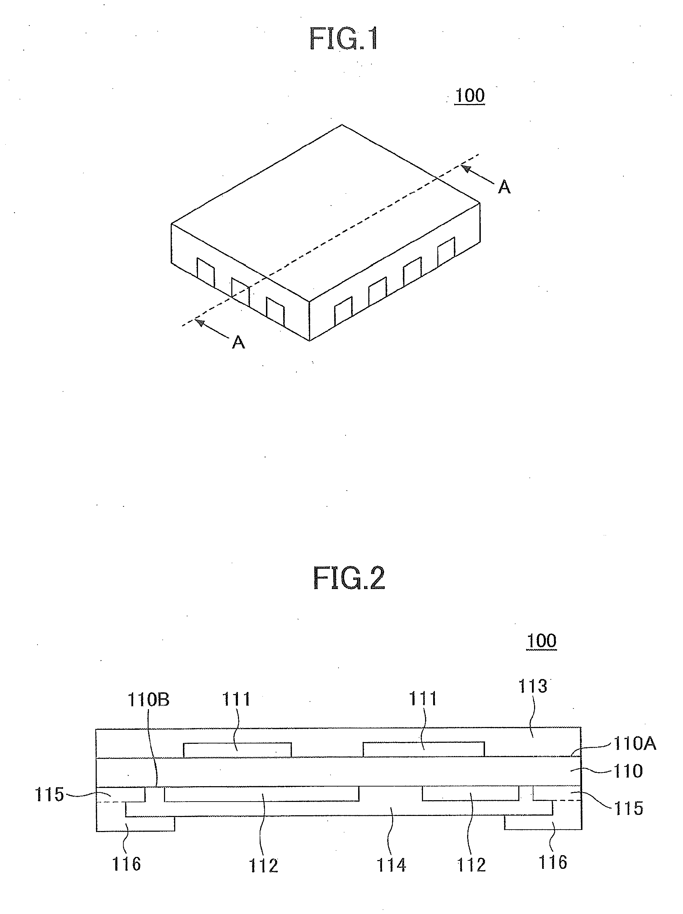

Next, a first embodiment of the present invention is described with reference to figures. FIG. 1 illustrates a high frequency module of a first embodiment.

The high frequency module 100 of the first embodiment is configured such that electronic parts mounted on a circuit board is sealed by a resin or the like. The high frequency module 100 of the first embodiment is to be mounted on a communication apparatus performing wireless communication. The high frequency module 100 is mounted on, for example, a wireless local area network (LAN) apparatus, a one segment tuner apparatus, an apparatus for global positioning system (GPS), or the like. FIG. 2 is a cross-sectional view of the high frequency module taken along a line A-A.

In the high frequency module 100, electronic parts 111 and electronic parts 112 are formed on one surface 110A and the other surface 110B of the circuit board 110, respectively. The circuit board 110 of the first embodiment is made of, for example, a ceramic, an epoxy resin, or the like. Further, the high frequency module 100 includes a resin molded layer 113 formed to cover the electronic parts 111, which are mounted on the surface 110A and a resin molded layer 114 formed to cover the electronic parts 112, which are mounted on the surface 110B. Further, the high frequency module 100 of the first embodiment includes terminals 115 formed on the surface 110B and electrodes 116 formed on the terminals 115 so as to draw the terminals 115 outside the resin molded layer 114.

Although it is not illustrated, it is preferable to make the surfaces of the resin molded layers 113 and 114 shield layers for cutting influences of noise or the like off.

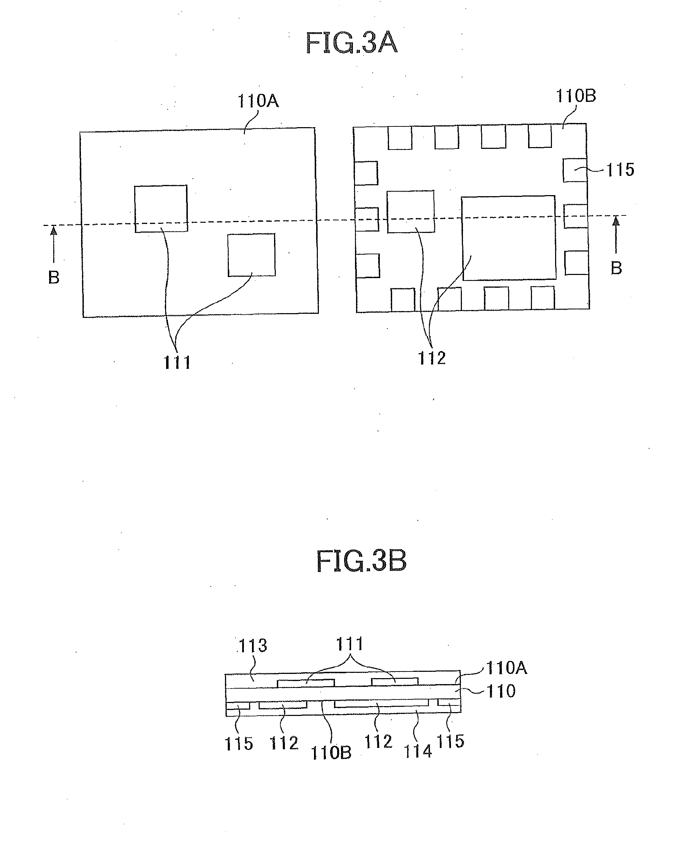

These terminals 115 are connected with the electronic parts 111 and 112 mounted on the board 110. Within the first embodiment, when the high frequency module 100 is mounted on the communication apparatus, the electrodes 116 are arranged so as to connect the board of the communication apparatus. Thus, the electronic parts 111 and 112 mounted on the board 110 can be connected with the board of the communication apparatus through the terminals and the electrodes 116. Although it is not illustrated in FIG. 3A, the electronic parts 111 and 112 mounted on the surfaces 110A and 110B are connected with the terminals 115 formed on the surfaces 110A and 110B.

FIGs. 3A to 3D illustrate a method of manufacturing the high frequency module of the first embodiment. Referring to FIG. 3A, the surfaces 110A and 110B of the board 110 of the high frequency module 100 are illustrated. The electronic parts 111 mounted on the surface 110A may be a part including, for example, a quartz oscillator or the like. The electronic part 112 mounted on the surface 110B may be a part related to communication, a power supply circuit of the high frequency module 100 or the like. Within the first embodiment, by mounting a part used for communication on the surface 110B, when the high frequency module 100 is mounted on the communication apparatus, the electronic parts 112 are hermetically sealed between the surface 110B and the board of the communication apparatus. Therefore, a shielding effect for the electronic parts 112 can be prospected.

After the electronic parts 111 and 112 are mounted on the board 110, the surface 110A is sealed by molding a resin. Thus, the resin molded layer 113 covering the electronic parts 111 is formed. Also, the surface 110B is sealed by molding a resin. Thus, the resin molded layer 114 covering the electronic parts 112 and the terminals 115 is formed. FIG. 3B is a cross-sectional view taken along a line B-B of FIG. 3A.

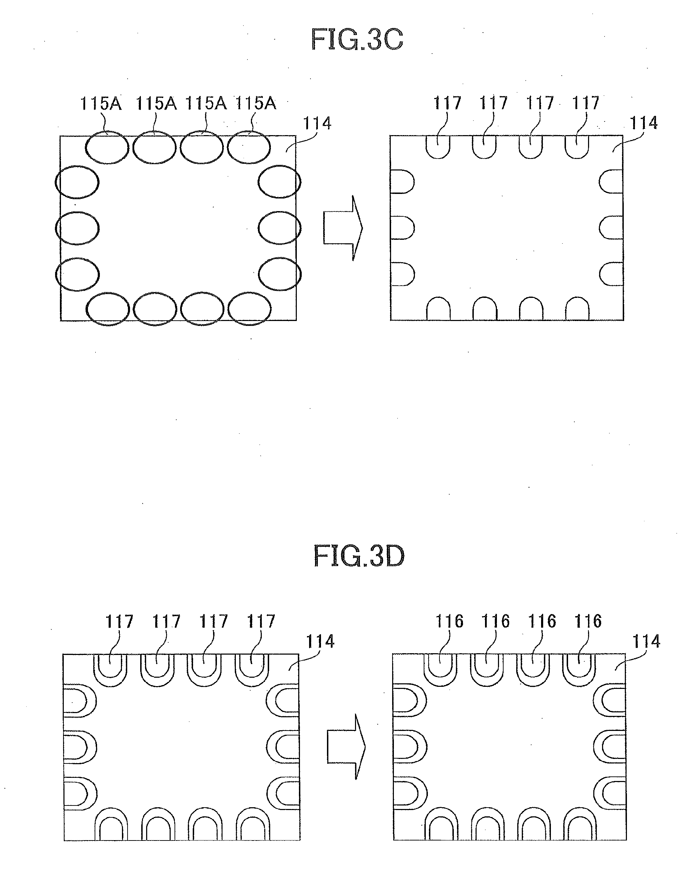

Referring to FIG. 3C, holes 117 reaching the terminals 115 are formed in areas 115A on the surface of the resin molded layer 114. The areas 115A correspond to the terminals 115 so as to overlap when viewed on the surface of the resin molded layer 114. It is preferable to process to form the holes 117 using, for example, laser. Referring to FIG. 3D, copper paste fills the holes 117 using a mask. Thus, the electrodes 116 are formed.

Within the first embodiment, the electrodes 116 are formed by pouring the copper paste into the holes 117, which are formed in the resin molded layer 114. Therefore, referring to FIG. 2, the resin molded layer 114 and the electrodes 116 are successively formed in the high frequency module 100 of the first embodiment.

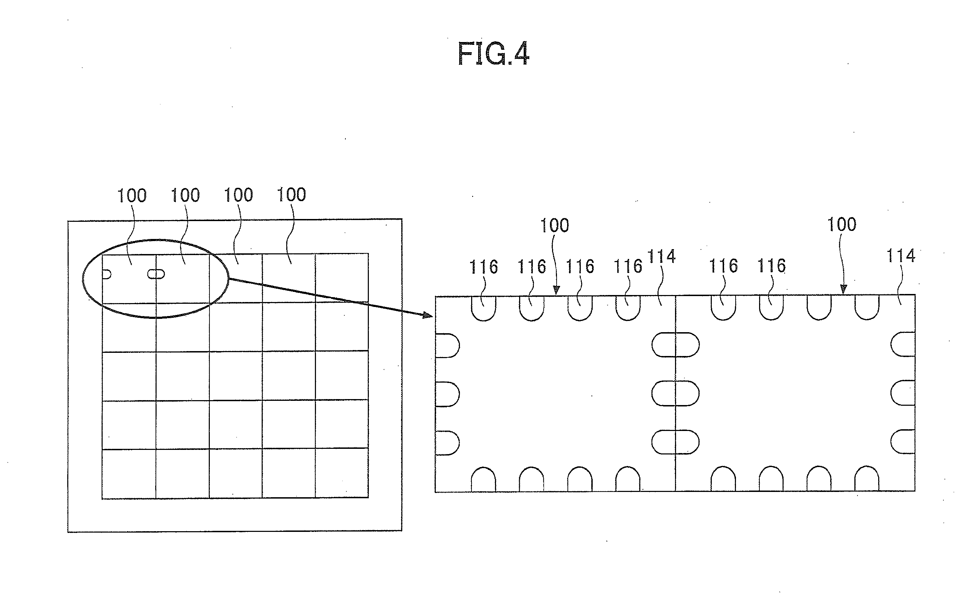

Referring to FIG. 4, a plurality of the high frequency modules 100 are simultaneously formed. After the processes illustrated in FIGs. 3A to 3D are completed, a dicing process is done. Thus, a plurality of high frequency modules 100 is obtainable. FIG. 4 illustrates dicing of the high frequency module of the first embodiment.

By forming the high frequency module 100 as described above, the high frequency module 100 includes the electronic parts 111 and 112 mounted on both surfaces of the board 110 and electrodes 116, which are to be connected with the communication apparatus and are formed on the surface of the resin molded layer 114. Therefore, when the high frequency module 100 is mounted on the main body of the communication apparatus, by arranging the surface, on which the electrodes 116 are formed, so as to contact the board of the communication apparatus, it is possible to connect the electronic parts inside the high frequency module 100 with a circuit on the side of a communication circuit.

Further, the high frequency module 100 of the first embodiment includes the electronic parts 111 and 112 mounted on both surfaces of the board 110, and the electrodes 116 so that the resin molded layer 114 and the electrodes 116 are successively formed. Therefore, in the high frequency module 100 of the first embodiment, it becomes unnecessary to process to form a space for double-side mounting the parts between the main body of the communication apparatus and the board 110. Then, the manufacturing process and the cost can be reduced. Further, in the high frequency module 100 of the first embodiment, it is unnecessary to use a shield case made of a metal and the double-side mounting is possible. Therefore, the high frequency module 100 of the first embodiment contributes to miniaturization and thinness of the entire high frequency module 100.

### (Second Embodiment)

Next, a second embodiment of the present invention is described with reference to figures. The second embodiment of the present invention differs from the first embodiment at points that the electrodes for drawing the terminals 115 on the surface of the resin molded layer 114 are previously mounted on the board. Within the second embodiment, reference symbols similar to those used in the explanation of the first embodiment are used for portions having functions similar to those in the first embodiment, and description of these portions is omitted.

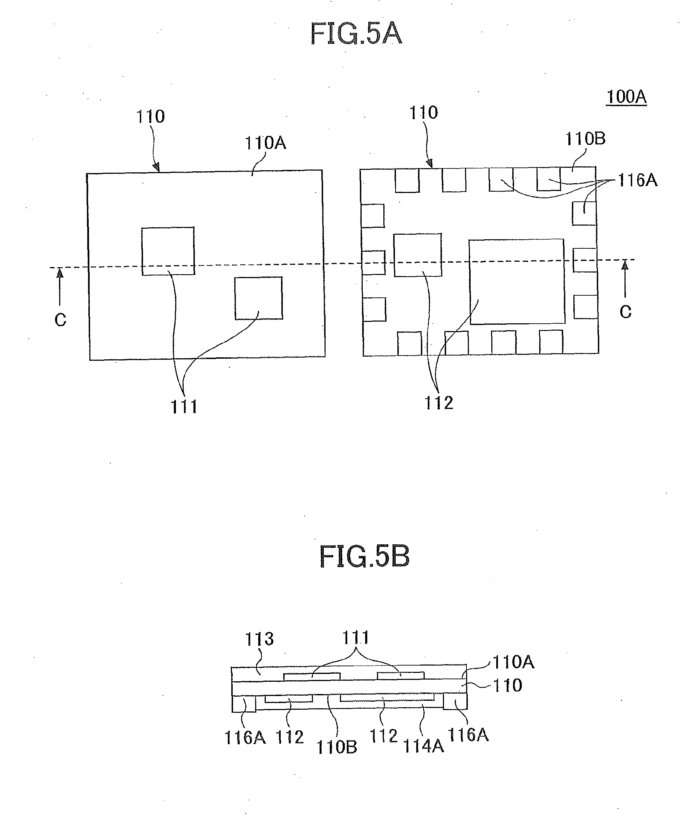

FIGs. 5A to 5C illustrate a method of manufacturing the high frequency module of the second embodiment. In a high frequency module 100A of the second embodiment, a part to be an electrode part 116A is previously mounted on the board 110.

Referring to FIG. 5A, on a surface 110B of the second embodiment, the electrode parts 116A are mounted at positions where the terminals 115 are to be formed. A detailed shape of the electrode part 116A is described later.

Within the second embodiment, the surface 110A is sealed by molding a resin. Thus, the resin molded layer 113 is formed so as to cover the electronic parts 111. Further, the surface 110 is also sealed by molding a resin. Thus, a resin molded layer 114A is formed so as to cover the electronic parts 112.

Within the second embodiment, as illustrated in FIG. 5B, the resin molded layer 114A is formed by sheet molding so that the electrode parts 116A protrude from the resin molded layer 114A by several tens µm. FIG. 5B is a cross-sectional view taken along a line C-C of FIG. 5A.

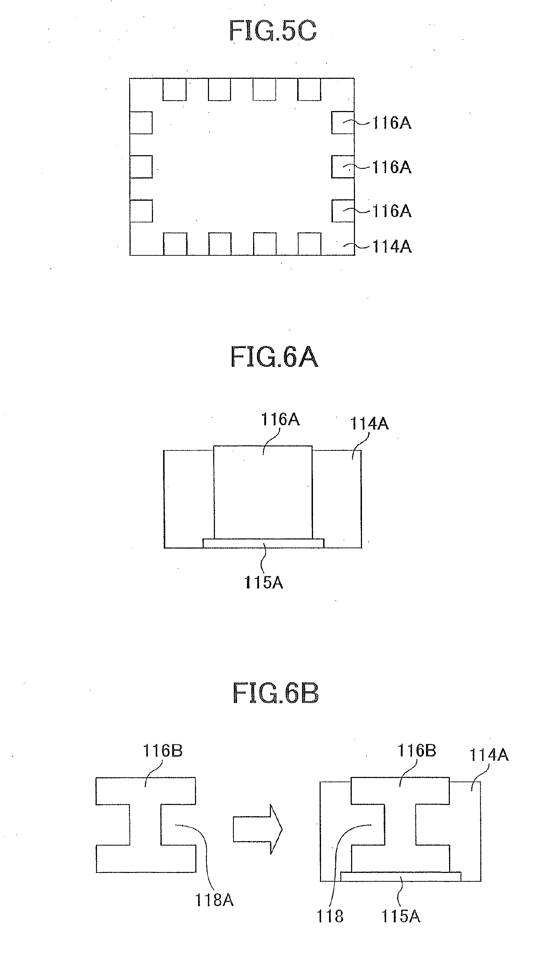

By forming the high frequency module 100A as described above, the high frequency module 100A includes the electronic parts 111 and 112 mounted on both surfaces of the board 110 and electrodes 116A, which are to be connected with the communication apparatus and are formed so that the electrodes 116A and the surface of the resin molded layer 114A are successively formed. FIG. 5C is a bottom view of the high frequency module 100A viewed from a lower side of FIG. 5B.

Hereinafter, referring to FIGs. 6A to 6E, the shape of the electrode parts 116A of the second embodiment is described. FIGs. 6A to 6E illustrate the electrode part of the high frequency module of the second embodiment. FIGs. 6A to 6E are upside-down in comparison with FIG. 2.

FIG. 6A illustrates an example of the electrode parts 116A (a first figure). The cross-sectional shape of the electrode part 116A is, for example, a rectangle. The electrode part 116A is joined to the board 110 through a solder surface 115A.

Referring to FIG. 6B, the electrode part 116B is shaped like a letter

"H" having a dent 118A in its cross-sectional view. By adopting this shape, a molded resin flows into the dent 118A when a resin molded layer 114A is formed. Therefore, when the high frequency module 100A is mounted on the communication apparatus or the like by, for example, reflow, it is possible to prevent the electrode part 116B from being dropped off or from being disarranged even if the solder surface 115A joining the electrode part 116B to the surface 110B is molten.

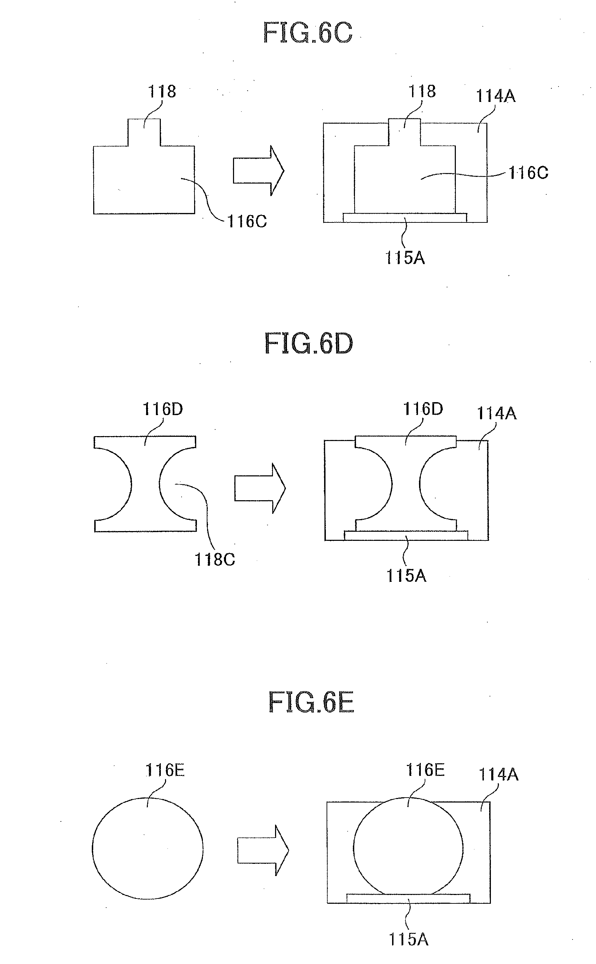

FIGs. 6C to 6E illustrate examples of the shapes of the electrode parts for preventing the electrode parts from being dropped off or from being disarranged even if the solder surface 115A is molten in a manner similar to FIG. 6B. An electrode part 116C illustrated in FIG. 6C includes a protrusion 118B. An electrode part 116D illustrated in FIG. 6D includes a semicircular recess 118C in its cross-sectional view. The electrode part 116E illustrated in FIG. 6E is formed by a solder ball. Within the second embodiment, a preferable shape of the electrode part is that a contact area between the electrode part and the resin molded layer 114A is great.

As described above, the high frequency module 100A of the second embodiment is formed such that the resin molded layer 114A is formed after the electronic parts 112 and the electrode parts are mounted on the surface 110B. Therefore, it is unnecessary to provide a space between the main body of the communication apparatus and the board 110. Thus, the manufacturing process and the cost can be reduces.

Further, referring to FIGs. 6A to 6E, side surfaces of the electrode parts 116B to 116E contact side surfaces of the resin molded layer (a first insulating layer) 114A and is simultaneously engaged with the side surfaces of the resin molded layer (a first insulating layer) 114A. Therefore, the electrode parts 116B to 116E are prevented from being dropped off or from being disarranged.

Further, in the high frequency module 100A of the second embodiment, it is unnecessary to use a shield case made of a metal and the double-side mounting is possible. Therefore, the high frequency module 100 of the second embodiment contributes to miniaturization and thinness of the entire high frequency module 100.

### (Third Embodiment)

Next, a third embodiment of the present invention is described in reference of figures. The third embodiment is different from the first embodiment at a point that the high frequency module and the antenna are integrally formed. Within the third embodiment, reference symbols similar to those used in the explanation of the first embodiment are used for portions having functions similar to those in the first embodiment, and description of these portions is omitted.

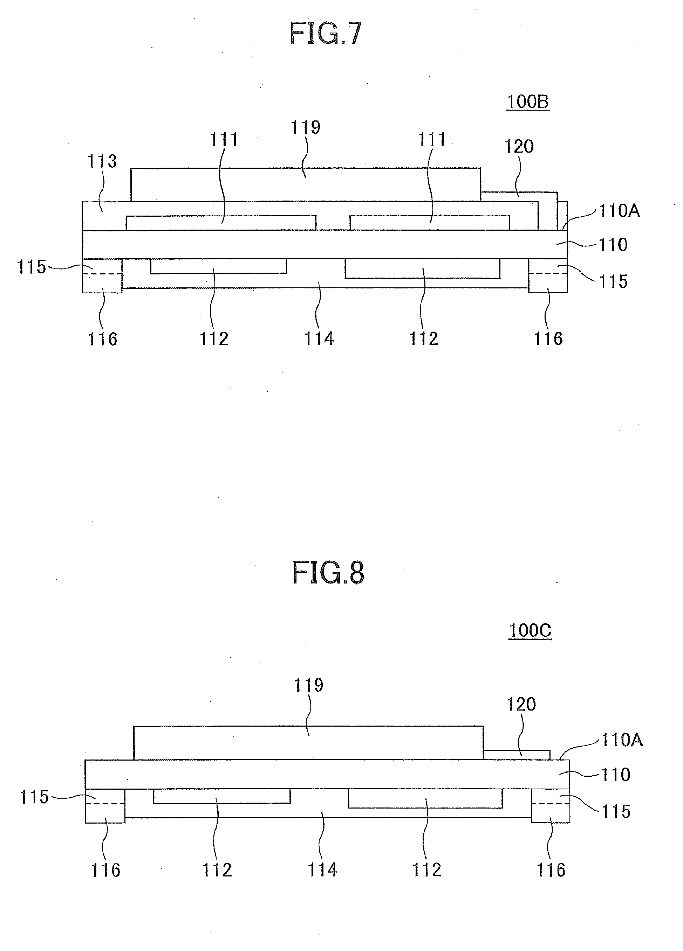

FIG. 7 illustrates a high frequency module of the third embodiment (a first figure). A high frequency module 100B illustrated in FIG. 7 includes an antenna 119 formed on the surface of the resin molded layer 113 and a surface layer 120 for connecting the terminal 115 with the antenna 119.

Referring to FIG. 7, it is exemplified that the antenna and the surface layer 120 are formed in the high frequency module 100. However, the antenna 119 and the surface layer 120 may be formed in the high frequency module 100A of the second embodiment.

FIG. 8 illustrates a high frequency module of the third embodiment (a second figure). In a high frequency module 100C illustrated in FIG. 8, the antenna 119 and the surface layer 120 are formed on the surface 110A of the board 110 (like the electronic parts 111). The structure illustrated in FIG. 8 is applicable to a mode of mounting the electrode parts 116A on the surface 110B of the board 110.

Further, the antenna 119 and the surface layer 120 of the third embodiment may be formed in the manufacturing process for, for example, the high frequency module 100C. For example, as illustrated in FIG. 4, when the plurality of high frequency modules 100C is connected, the antennas 119 and the surface layers 120 may be simultaneously formed.

### (Fourth Embodiment)

Hereinafter, a fourth embodiment of the present invention is described with reference to figures. Within the fourth embodiment of the present invention, a high frequency module is mounted on a communication apparatus while the high frequency module is joined to a connector. Within the fourth embodiment, reference symbols similar to those in the first embodiment are used for portions having functions similar to those in the first embodiment, and description of these portions is omitted.

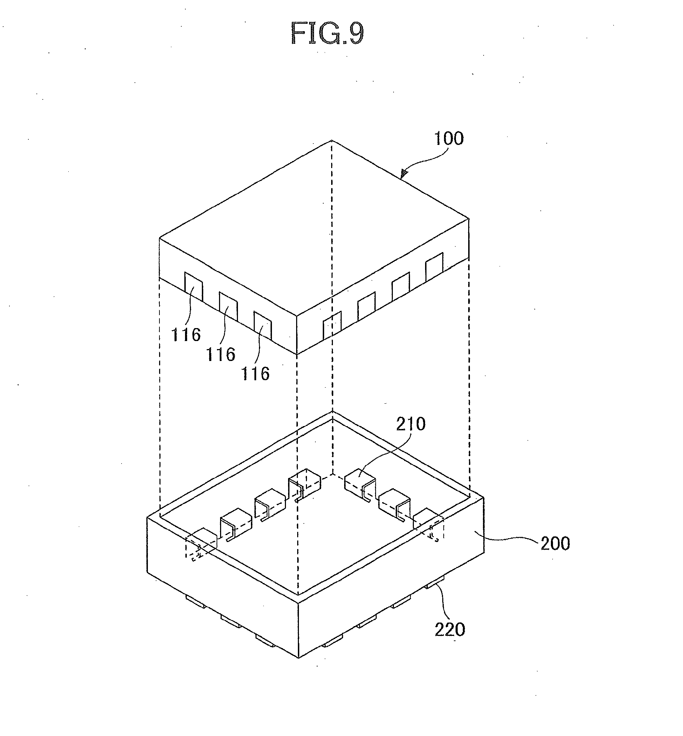

FIG. 9 illustrates a high frequency module of the fourth embodiment. Within the fourth embodiment, the high frequency module 100 is accommodated in the connector 200 mounted on the board of the communication apparatus.

Pins 210 and electrodes 220 are formed in the connector 200. When the high frequency module 100 is accommodated in the connector 200, the electrodes 116 contact the pins 210 while pressing the electrodes 116 onto the pins 210. Thus, the high frequency module 100 is connected with the connector 200. The electrodes 220 are integrally formed with the pins 210. The electrodes 220 are connected with the electrodes 116 through the pins 210.

As described, when the high frequency module 100 can be accommodated in the connector 200, it is possible to deal with a case where the high frequency module is required to be connected with the connector as authentication for receiving a high frequency signal.

Referring to FIG. 9, an example that the high frequency module 100 is accommodated in the connector 200 is described. The fourth embodiment is similarly applicable to the high frequency modules 100A, 100B, and 100C of the second and third embodiments.

Although the invention has been described with respect to specific embodiments for a complete and clear disclosure, the appended claims are not to be thus limited but are to be construed as embodying all modifications and alternative constructions that may occur to one skilled in the art that fairly fall within the basic teachings herein set forth.

This patent application is based on Japanese Priority Patent Application No. 2011-006314 filed on January 14, 2011, the entire contents of which are hereby incorporated herein by reference.

### EXPLANATION OF REFERENCE SIGNS

100, 100A, 100B, 100C : high frequency module;
110 : board;
111, 112 : electronic part;
113, 114 : resin molded layer;
115 : terminal;
116 : electrode; and
116A : electrode part.

## Claims

1. A high frequency module comprising:
a part mounted on one surface of a board;
an electrode for connecting the part formed on the one surface and an apparatus for mounting the high frequency module; and
a first insulating layer, which is formed on the one surface and is configured to cover the part,
wherein the electrode is formed on a surface of the first insulating layer such that at least a part of the electrode and the first insulating layer are successively formed.

2. The high frequency module according to claim 1, further comprising:
another part mounted on another surface of the board; and
a second insulating layer formed to cover said another part mounted on said another surface.

3. The high frequency module according to claim 2, further comprising:
an antenna pattern, which is formed on a surface of the second insulating layer and is configured to receive a high frequency signal.

4. The high frequency module according to claim 2, further comprising:
an antenna pattern, which is formed on said another surface of the board and is configured to receive a high frequency signal.

5. The high frequency module according to claim 2,
wherein the electrode and the first insulating layer are successively formed so that a side surface of the electrode is secured to a side surface of the first insulating layer while the side surface of the electrode contacts the side surface of the first insulating layer.
